# EUROPEAN PATENT SPECIFICATION

(11) **EP 2 858 127 B1**
(45) Date of publication and mention of the grant of the patent: **30.05.2018**
(21) Application number: 14186324.1
(22) Date of filing: 25.09.2014
(51) Int. Cl.: H01L 33/06, H01L 33/14, H01L 33/32

(54) **Light emitting diode**
Leuchtdiode
Diode électroluminescente

(30) Priority: 02.10.2013 KR 20130118096
(43) Date of publication of application: 08.04.2015
(73) Proprietor: LG Innotek Co., Ltd., Seoul, 04637 (KR)
(72) Inventor: Park, Chan Keun, 100-714 Seoul (KR)
(74) Representative: Zardi, Marco

(56) References cited:
- EP-A2- 2 503 603
- EP-A2- 2 551 923

## Description

### CROSS-REFERENCE TO RELATED APPLICATION

This application claims the priority benefit of Korean Patent Application No. 10-2013-0118096, filed on October 2, 2013 in the Korean Intellectual Property Office.

### BACKGROUND

### 1. Field

Embodiments relate to a light emitting device to produce ultraviolet light.

### 2. Description of the Related Art

A light emitting diode (LED) as a representative example of a light emitting device is a device which converts electrical signals into infrared light, visible light or ultraviolet light using characteristics of compound semiconductors. LEDs are now being applied to devices such as home appliances, remote controls, electronic signboards, displays, a variety of automatic appliances and the like and applications thereof continue to expand.

Generally, a miniaturized LED is fabricated as a surface mount device so as to be directly mounted to a printed circuit board (PCB). Accordingly, an LED lamp used as a display device is also developed as a surface mount device. Such a surface mount device may replace conventional simple lamps and is used in lighting displays, character displays, image displays and the like which render various colors.

As the application range of LEDs expands, luminance required for lightings for daily use and lightings for distress signals increases. Accordingly, it is important to increase luminance of LEDs.

In addition, it is important to improve recombination probability between electrons and holes in an active layer of light emitting devices. In particular, in UV light emitting devices producing light of the ultraviolet range, a composition ratio of Al in a semiconductor layer increases, an activation energy required for severing Mg-H complexes and forming Mg+ ions increases, a hole density in p regions decreases and luminous efficacy decreases. In addition, disadvantageously, contact resistance at the semiconductor layer boundary surface increases and operation voltage increases.

EP 2 503 603 A2 discloses a light emitting device including a first conductive semiconductor layer, an active layer comprising a well layer and a barrier layer on the first conductive layer, and a second conductive semiconductor layer on the active layer, wherein the well layer includes a first well layer closest to the first conductive semiconductor layer and having a first energy bandgap, a third well layer closest to the second conductive semiconductor layer and having a third energy bandgap, and a second well layer interposed between the first and third well layers and having a second energy bandgap. The third energy bandgap of the third well layer is greater than the second energy bandgap of the second well layer.

### SUMMARY

Embodiments provide a light emitting diode (LED, in the following also referred to as light emitting device for producing ultraviolet light to increase injection of holes and improve luminous efficacy.

In one embodiment, a light emitting diode includes, inter alia, a first semiconductor layer doped with an n-type dopant, a second semiconductor layer doped with a p-type dopant, an active layer disposed between the first semiconductor layer and the second semiconductor layer, the active layer being formed of InxAlyGa1-x-yN (0≤x≤1, 0≤y≤1, 0≤x+y≤1) and including a plurality of barrier layers and a plurality of well layers, the well layers being interposed between the barrier layers and having a smaller bandgap energy than that of the barrier layers, an intermediate layer interposed between the active layer and the second semiconductor layer, the intermediate layer being formed of InaAlbGa1-a-bN (0≤a≤1, 0≤b≤1, 0≤a+b≤1) and having a smaller bandgap energy than that of the barrier layers, and a blocking layer disposed between the intermediate layer and the second semiconductor layer, the blocking layer being formed of InzAlwGa1-z-wN (0≤z≤1, 0≤w≤1, 0≤z+w≤1) and having a greater bandgap energy than that of each of the barrier layers and the intermediate layer, the intermediate layer doped with a p-type dopant.

### BRIEF DESCRIPTION OF THE DRAWINGS

Details of the embodiments will be more clearly understood from the following detailed description taken in conjunction with the accompanying drawings, in which:
FIG. 1 is a sectional view illustrating a light emitting device according to an embodiment;
FIG. 2 is a partially enlarged view of the part A of FIG. 1;
FIG. 3 is an energy band diagram illustrating the light emitting device according to the embodiment shown in FIG. 1;
FIG. 4 is a sectional view illustrating a light emitting device according to another embodiment;
FIG. 5 is a sectional view illustrating a light emitting device package including the light emitting device according to the present embodiment.
FIG. 6 is an exploded perspective view illustrating a display device including a light emitting device according to an embodiment;
FIG. 7 is a sectional view illustrating the display device of FIG. 6; and
FIG. 8 is an exploded perspective view illustrating a lighting device including the light emitting device according the embodiment.

### DETAILED DESCRIPTION OF EMBODIMENTS

Reference will now be made in detail to embodiments, examples of which are illustrated in the accompanying drawings. However, the present disclosure may be embodied in many different forms and should not be construed as limited to the embodiments set forth herein. Rather, these embodiments are provided so that this disclosure will be thorough and complete, and will fully convey the scope of the disclosure to those skilled in the art. The present disclosure is defined only by the categories of the claims. In certain embodiments, detailed descriptions of device constructions or processes well known in the art may be omitted to avoid obscuring appreciation of the disclosure by a person of ordinary skill in the art. Wherever possible, the same reference numbers will be used throughout the drawings to refer to the same or like parts.

Spatially relative terms such as "below", "beneath", "lower", "above", or "upper" may be used herein to describe one element's relationship to another element as illustrated in the figures. It will be understood that spatially relative terms are intended to encompass different orientations of the device in addition to the orientation depicted in the Figures. For example, if the device in one of the figures is turned over, elements described as "below" or "beneath" other elements would then be oriented "above" the other elements. The exemplary terms "below" or "beneath" can, therefore, encompass both an orientation of above and below. Since the device may be oriented in another direction, the spatially relative terms may be interpreted in accordance with the orientation of the device.

The terminology used in the present disclosure is for the purpose of describing particular embodiments only and is not intended to limit the disclosure. As used in the disclosure and the appended claims, the singular forms "a", "an" and "the" are intended to include the plural forms as well, unless context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

In the drawings, the thickness or size of each layer is exaggerated, omitted, or schematically illustrated for convenience of description and clarity. Also, the size or area of each constituent element does not entirely reflect the actual size thereof.

Angles or directions used to describe the structures of light emitting devices according to embodiments are based on those shown in the drawings. Unless there is, in the specification, no definition of a reference point to describe angular positional relations in the structures of the light emitting devices, the associated drawings may be referred to.

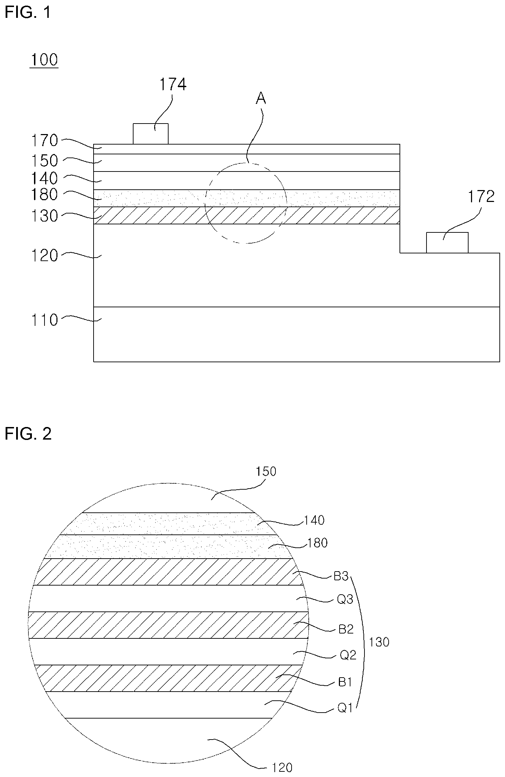

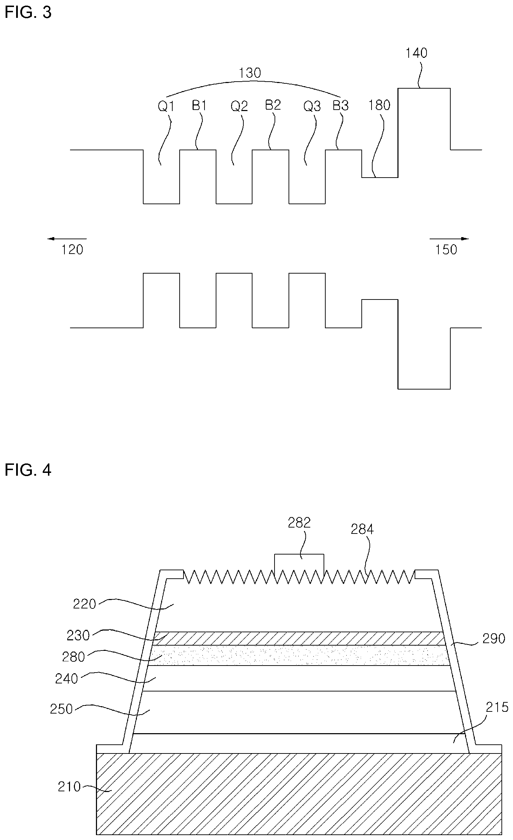

FIG. 1 is a sectional view illustrating a light emitting device according to an embodiment, FIG. 2 is a partially enlarged view of the part A of FIG. 1 and FIG. 3 is an energy band diagram illustrating the light emitting device according to the embodiment shown in FIG. 1.

Referring to FIG. 1, the light emitting device 100 according to the present embodiment includes a substrate 110 and a light-emitting structure disposed on the substrate, and the light-emitting structure includes a first semiconductor layer 120, an active layer 130, an intermediate layer 180, a blocking layer 140 and a second semiconductor layer 150.

The substrate 110 may be made of a light-transmitting material such as sapphire (Al2O3), GaN, ZnO, or AIO, but the disclosure is not limited thereto. In addition, the substrate 110 may be formed of a carrier wafer which is a material suitable for growth of semiconductor materials. The substrate 110 may be formed of a material having a high thermal conductivity and may include a conductive or insulating substrate, for example, a SiC substrate having a higher thermal conductivity than the sapphire (Al2O3) substrate, or at least one of Si, GaAs, GaP, InP, and Ga2O3.

Meanwhile, a patterned substrate (PSS) structure such as an irregular structure may be provided on the front surface of the substrate 110 to improve light extraction efficiency. The substrate 110 mentioned herein may or may not have a PSS structure.

Meanwhile, a buffer layer (not shown) may be disposed on the substrate 110 to prevent lattice mismatch between the substrate 110 and the first conductive semiconductor layer 120 and enable easy growth of the semiconductor layer. The buffer layer (not shown) may be formed under a low temperature atmosphere and be formed of a material to reduce lattice mismatch between the substrate 110 and the first conductive semiconductor layer 120. For example, the buffer layer may comprise a material such as GaN, InN, AlN, AlInN, InGaN, AlGaN or InAlGaN, but the disclosure is not limited thereto.

The buffer layer (not shown) may be grown in the form of a single crystal on the substrate 110 and the buffer layer grown in the form of the single crystal improves crystallinity of the first semiconductor layer 120 grown on the buffer layer (not shown).

The light emitting structure including the first semiconductor layer 120, the active layer 130, the intermediate layer 180, the blocking layer 140 and the second semiconductor layer 150 may be formed on the buffer layer (not shown).

The first semiconductor layer 120 may be disposed on the buffer layer (not shown). The first semiconductor layer 120 may be formed of a semiconductor compound and may be doped with a first conductive type dopant. For example, the first semiconductor layer 120 may be implemented with an n-type semiconductor layer and supply electrons to the active layer 130. The first semiconductor layer 120 may be selected from semiconductor materials having a formula of InxAlyGa1-x-yN (0≤x≤1, 0 ≤y≤1, 0≤x+y≤1), such as GaN, AlN, AlGaN, InGaN, InN, InAlGaN, AlInN, and the like and may be doped with an n-type dopant such as Si, Ge, Sn, Se, or Te. In the case of a UV light emitting device, the first semiconductor layer may comprise AIGaN.

In addition, the light emitting device may further include an undoped semiconductor layer (not shown) under the first semiconductor layer 120, but the disclosure is not limited thereto. The undoped semiconductor layer serves to improve crystallinity of the first semiconductor layer 120 and is the same as the first semiconductor layer 120 except that the undoped semiconductor layer has lower electrical conductivity than the first semiconductor layer 120 because it is not doped with an n-type dopant.

The active layer 130 is formed on the first conductive semiconductor layer 120. The active layer 130 may be formed with a single or multi-quantum well structure, a quantum wire structure, a quantum dot structure or the like using a compound semiconductor material composed of Group III-V elements.

In the light emitting device 100 of the present embodiment, the active layer 130 is a quantum well structure. The active layer 130 is disposed between the first semiconductor layer and the second semiconductor layer and has a formula of InxAlyGa1-x-yN (0≤x≤1, 0≤y≤1, 0≤x+y≤1). That is, AlN, GaN and InN layers may be alternately disposed. The active layer 130 has a single or multi-quantum well structure including a plurality of barrier layers B and a plurality of well layers Q disposed between the barrier layers B. According to the embodiment, the well layers Q and the barrier layers B may be alternately disposed. The numbers of the well layers Q and the barrier layers B may be 3 to 5.

Each well layer Q is formed of a material having a smaller bandgap energy than each barrier layer B. As Al content of the well layer Q increases, freedom degree of bandgap energy increases, lattice constant increases, luminous efficacy increases and wavelength of emitted light shortens. The wavelength of light may be determined according to composition and thickness of the semiconductor layer.

The active layer 130 produces light of an ultraviolent (UV) range with a wavelength of 325 nm to 385 nm. Light of an ultraviolet range may be produced when a composition ratio of the barrier layer B to the well layer Q is 0 to 0.7 and the Al content of the barrier layer B is higher than that of the well layer Q. When Al composition ratio of the well layer and the barrier layer is 0.7 or more, lattice mismatch between the AlN and GaN layers increases and surface defects are thus generated.

Al contents, different energy bandgap structures of the well layer Q and the barrier layer B, and the like of the active layer 130 with a multi-quantum well structure will be described in detail with reference to FIGS. 2 and 3.

A conductive clad layer (not shown) may be disposed on and/or under the active layer 130. The conductive clad layer (not shown) may be formed of a semiconductor and may have a greater band gap than that of the active layer 134. For example, the conductive clad layer (not shown) may comprise AlGaN.

The second semiconductor layer 150 is formed of a semiconductor compound for injecting holes into the active layer 130 and is doped with a second conductive type dopant. According to the invention as claimed, the second semiconductor layer 150 is implemented with a p-type semiconductor layer. The second semiconductor layer 150 is for example formed of a semiconductor materiel having a formula of InxAlyGa1-x-yN (0≤x≤1, 0≤y≤1, 0≤x+y≤1), for example, selected from GaN, AlN, AlGaN, InGaN, InN, InAlGaN, AlInN and the like and is doped with a p-type dopant such as Mg, Zn, Ca, Sr, or Ba. In UV light emitting devices, the second semiconductor layer may comprise AIGaN.

The intermediate layer 180 is disposed between the active layer 130 and the second semiconductor layer and is formed of InaAlbGa1-a-bN (0≤a≤1, 0≤b≤1, 0≤a+b≤1). The intermediate layer 180 has a smaller bandgap energy than that of each barrier layer B. When the intermediate layer 180 is disposed between the active layer 130 and the blocking layer 140, the effect of injecting holes into the active layer 130 can be improved.

The Al content of the intermediate layer 180 is less than that of the barrier layer B and the blocking layer 140 and is greater than that of the well layer Q. The Al content means a ratio of Al weight or mass in the composition.

The intermediate layer 180 may be doped with a p-type dopant such as Mg, Zn, Ca, Sr, or Ba. A doping concentration of the intermediate layer 180 may be 1E18 to 1E20 cm-3.

A blocking layer 140 is, according to the invention as claimed, disposed between the intermediate layer 180 and the second semiconductor layer 150. The blocking layer 140 is formed of a semiconductor material having a formula of InzAlwGa1-z-wN (0≤z≤1, 0≤w≤1, 0≤z+w≤1) and has a greater lattice constant than the second semiconductor layer 150. In UV light emitting devices, the blocking layer comprises AlGaN. The blocking layer 140 has a greater bandgap energy than that of the active layer 130 and the intermediate layer 180.

Upon application of a high current, the blocking layer 140 prevents a phenomenon in which electrons injected from the first semiconductor layer 120 into the active layer 130 are not recombined in the active layer 130 and flow to the second semiconductor layer 150. The blocking layer 140 has a greater bandgap than that of the active layer 130 and prevents a phenomenon in which electrons injected from the first semiconductor layer 120 are separated from the active layer 130 and injected into the second semiconductor layer 150. As a result, the probability of recombination between electrons and holes in the active layer 130 is increased and current leakage is thus prevented.

The blocking layer 140 is, according to the invention, doped with a p-type dopant. The blocking layer 140 doped at a high p-type doping concentration facilitates injection of holes into the active layer 130.

The blocking layer 140 may comprise AlGaN and may have a higher Al content than that of the active layer 130 and the intermediate layer 180. The blocking layer 140 has a greater bandgap energy than that of the active layer 130 and the intermediate layer 180.

The first semiconductor layer 120, the active layer 130, the intermediate layer 180, the blocking layer 140 and the second semiconductor layer 150 may for example be formed by a method such as metal organic chemical vapor deposition (MOCVD), chemical vapor deposition (CVD), plasma-enhanced chemical vapor deposition (PECVD), molecular beam epitaxy (MBE), hydride vapor phase epitaxy (HVPE) and sputtering, but the disclosure is not limited thereto.

In addition, doping concentrations of conductive dopants in the first semiconductor layer 120 and the second semiconductor layer 150 may be uniform or non-uniform. That is, the semiconductor layers may have various doping concentration distributions, but the disclosure is not limited thereto.

In addition, the first semiconductor layer 120 may be implemented with a p-type semiconductor layer, the second semiconductor layer 150 may be implemented with an n-type semiconductor layer and a third semiconductor layer (not shown) including an n- or p-type semiconductor layer having an opposite polarity to that of the second semiconductor layer 150 may be formed on the second semiconductor layer 150. Accordingly, the light emitting device 100 may have at least one of np, pn, npn and pnp junction structures.

A light-transmitting electrode layer 170 may be formed on the second semiconductor layer 150. The light-transmitting electrode layer 170 include at least one of ITO, IZO (In-ZnO), GZO (Ga-ZnO), AZO (Al-ZnO), AGZO (Al-Ga ZnO), IGZO (In-Ga ZnO), IrOx, RuOx, RuOx/ITO, Ni/IrOx/Au and Ni/IrOx/Au/ITO. Accordingly, the light-transmitting electrode layer 170 emits light generated in the active layer 130 to the outside and is formed in the entirety or part of an outer surface of the second semiconductor layer 150, thereby preventing current crowding.

Meanwhile, a first electrode 172 electrically connected to the first semiconductor layer 120 may be disposed on the first semiconductor layer 120. For example, the active layer 130 and the second semiconductor layer 150 may be partially removed to expose a part of the first semiconductor layer 120 and a first electrode 172 may be formed on the exposed first semiconductor layer 120. That is, the first semiconductor layer 120 has an upper surface facing the active layer 130 and a lower surface facing the substrate 110, wherein the upper surface has a region having at least one exposed portion and is disposed of the exposed portion of the upper surface of the first electrode 172, but the disclosure is not limited thereto.

Meanwhile, the exposure of the portion of the first semiconductor layer 120 may be carried out by a predetermined etching method, but the disclosure is not limited thereto. In addition, the etching method may be wet or dry etching.

In addition, a second electrode 174 is electrically connected to the second semiconductor layer 150. For example, the second electrode 174 may be formed on the second semiconductor layer 150.

Meanwhile, the first and second electrodes 172 and 174 may include a conductive material, for example, a metal selected from In, Co, Si, Ge, Au, Pd, Pt, Ru, Re, Mg, Zn, Hf, Ta, Rh, Ir, W, Ti, Ag, Cr, Mo, Nb, Al, Ni, Cu, and WTi, or an alloy thereof and may have a single or multiple layer structure, but the disclosure is not limited thereto.

Referring to FIG. 2, the active layer 130 of the light emitting device 100 has a multi-quantum well structure. Accordingly, the active layer 130 may include first to third well layers Q1, Q2 and Q3 and first to third barrier layers B1, B2 and B3.

In addition, the first to third well layers Q1, Q2 and Q3, and the first to third barrier layers B1, B2 and B3 may be alternately disposed, as shown in FIG. 2.

Meanwhile, as shown in FIG. 2, the first to third well layers Q1, Q2 and Q3, and the first to third barrier layers B1, B2 and B3 are formed and the first to third well layers Q1, Q2 and Q3, and the first to third barrier layers B1, B2 and B3 are alternately disposed, but the disclosure is not limited thereto. The well layers and the barrier layers may be present in plural and have a predetermined arrangement. According to one embodiment, the numbers of the well layers and the barrier layers are preferably 3 to 5. As the number of the well and barrier layers increases, the volume of the active layer 130 increases and luminous efficacy is improved. On the other hand, when the number of the well and barrier layers excessively increases, transfer of electrons and holes between the well layers is difficult and luminous efficacy is thus deteriorated.

Furthermore, as described above, content, bandgap and thickness of the material for forming the well layers Q1, Q2 and Q3 may be different from those of the barrier layers B1, B2 and B3 and are not limited to those shown in FIG. 2.

The Al content of the barrier layers B1, B2 and B3 is higher than those of the well layers Q1, Q2 and Q3 and intermediate layer 180 and is lower than that of the blocking layer 140. For example, the barrier layers B1, B2 and B3 comprise AIGaN, and the well layers Q1, Q2 and Q3 comprise InGaN.

The wavelength of light emitted from the well layers Q1, Q2 and Q3 can be controlled by adjusting the Al content of the well layers Q1, Q2 and Q3. As the Al content of the well layers Q1, Q2 and Q3 increases, the wavelength of emitted light shortens.

The barrier layers B1, B2 and B3 have a greater bandgap energy than that of the well layers Q1, Q2 and Q3. The bandgap energy of the barrier layers B1, B2 and B3 is smaller than that of the blocking layer 140 and is greater than that of the intermediate layer 180.

Each of the well layers Q1, Q2 and Q3 and the barrier layers B1, B2 and B3 may have a thickness of 4 to 20 nm. The thickness of the barrier layers B1, B2 and B3 is set to a predetermined value, thereby suppressing direct tunneling. When the thickness of the well layers Q1, Q2 and Q3 is excessively small, the well layers may be combined with the barrier layers, and when the thickness of the well layers Q1, Q2 and Q3 is excessively great, increment in bandgap by quantum effects is reduced and wavelength of emitted light is thus increased. When the thickness of the well layers Q1, Q2 and Q3 decreases, a shorter wavelength of light is produced. In particular, the third barrier layer B3 contacting the intermediate layer is not doped and prevents the doping material of the second semiconductor layer 150 from diffusing toward the third well layer Q3. When the thickness of the third barrier layer B3 is excessively small, the diffusion may occur and when the thickness is excessively great, the number of crystal defects may increase.

The intermediate layer 180 is disposed between the active layer and the second semiconductor layer. The intermediate layer 180 functions to reduce piezoelectric effect between the active layer 130 and the second semiconductor layer 150 and thereby improve injection efficiency of holes from the second semiconductor layer 150 to the active layer 130.

The intermediate layer 180 may comprise AlGaN. The Al content of the intermediate layer 180 is lower than that of the barrier layers B1, B2 and B3, and the blocking layer 140 and is higher than that of the well layers Q1, Q2 and Q3. In one embodiment, when Al contents of the third barrier layer B3 and the blocking layer 140 formed of AlGaN are 0.09 to 0.15, and 0.2 to 0.25, respectively, and the In content of the third well layer Q3 formed of InGaN is 0.01 or less. The Al composition ratio of the intermediate layer is according to the invention as claimed 0.02 to 0.13. That is, the Al content of the intermediate layer is 2 to 13%. When the Al content of the intermediate layer 180 is less than 2%, luminous efficacy by light absorption may be deteriorated and when the Al content of the intermediate layer 180 is higher than that of the third barrier layer B3, diffusion of the p-doping material occurs, thus causing deterioration in hole injection.

The intermediate layer 180 has a smaller bandgap energy than that of the barrier layers B1, B2 and B3 and the blocking layer.

The intermediate layer 180 may have a thickness of 2 nm to 30 nm. When the thickness of the intermediate layer 180 is less than 2 nm, piezoelectric polarization between the second semiconductor layer 150 and the active layer 130 cannot be reduced and when the thickness of the intermediate layer is greater than 30 nm, injection efficiency of holes from the second semiconductor layer 150 to the active layer 130 may be deteriorated, but the disclosure is not limited thereto.

They intermediate layer 180 is doped with a p-type dopant and the p-type dopant may include at least one of Mg, Zn, Ca, Sr and Ba. For example, the intermediate layer 180 may be doped with magnesium (Mg).

When the intermediate layer 180 is doped with a p-type dopant, the doping concentration may be 1E18 to 1E20 cm-3. The reason for this is that when the doping concentration of Mg is excessively low, improvement of injection efficiency of holes from the second semiconductor layer 150 to the active layer 130 is insufficient and when the doping concentration of Mg is excessively high, the amount of Mg diffused from the intermediate layer 180 to the active layer 130 increases and luminous efficacy of the light emitting device 100 is thus deteriorated.

Meanwhile, the bandgap energy of the intermediate layer 180 is higher than that of each of the well layers Q1, Q2 and Q3 and is lower than that of each of the barrier layers B1, B2 and B3 and the second semiconductor layer 150. When the bandgap energy of the intermediate layer 180 is excessively low, holes supplied from the second semiconductor layer 150 to the active layer 130 cannot be sufficiently confined, and when the bandgap energy is excessively high, the injection efficiency of holes from the second semiconductor layer 150 to the active layer 130 can be reduced. In the semiconductor layers, piezoelectric polarization resulting from stress caused by difference in lattice constant between the semiconductor layers and orientation may be generated. The semiconductor materials for forming the light emitting device have a high piezoelectric coefficient, thus causing considerably great polarization even at small strains. An electric field induced by two polarizations changes an energy band structure of the light emitting device, thus distorting distribution of electrons and holes. This is referred to as a quantum confined stark effect (QCSE) which results in low internal quantum efficiency in light emitting devices that generate light by recombination of electrons and holes and may have negative effects on electrical and optical properties, such as red shift of emission spectrum, of light emitting devices. In particular, such a strain further reinforces the polarization effect and enhances internal electric field, thus forming a sharp triangular potential well (between the second semiconductor layer 150 and the active layer 130) resulting from the band bent according to electric field. As a result, a phenomenon in which electrons or holes are concentrated in the triangular potential well is prevented. Accordingly, recombination rate of electrons and holes may be decreased. That is, injection efficiency of holes from the second semiconductor layer 150 to the active layer 130 may be disadvantageously decreased.

Meanwhile, crystal defects resulting from difference in lattice constant between the substrate 110 and the light-emitting structure formed on the substrate 110 tend to increase according to growth direction and the second semiconductor layer 150 formed at the position farthest from the substrate 110 may thus have the greatest number of crystal defects. When taking into consideration the fact that hole mobility is lower than electron mobility, deterioration in hole injection efficiency resulting from deterioration in crystallinity of the second semiconductor layer 150 may cause deterioration in luminous efficacy of the light emitting device 100.

As in the embodiment described above, when the intermediate layer 180 is disposed between the active layer 130 and the second semiconductor layer 150 and the intermediate layer 180 has a high lattice constant, formation of the triangular potential well may be reduced, recombination of electrons and holes is increased and luminous efficacy of the light emitting device 100 is thus improved. In addition, holes escaping from the second semiconductor layer 150 have a high energy and thus pass through the triangular potential well. Accordingly, luminous efficacy of the light emitting device 100 is improved.

The blocking layer 140 is disposed between the intermediate layer and the second semiconductor layer 150. The blocking layer 140 may contain AlGaN. The Al content of the blocking layer is higher than that of the third barrier layer B3 and the intermediate layer 180. The blocking layer 180 has a greater bandgap energy than that of each of the third barrier layer B3 and the intermediate layer 180.

FIG. 4 is a sectional view illustrating a light emitting device 200 according to another embodiment.

Referring to FIG. 4, the light emitting device 200 according to the present embodiment includes a support member 210, a second electrode layer 215 disposed on the support member 210, a light emitting structure including a second semiconductor layer 250, a blocking layer 240, an intermediate layer 280, an active layer 230 and a first semiconductor layer 220, and a first electrode layer 282. Composition, function, Al composition and bandgap energy relation of the light-emitting structure are the same as those of the embodiment shown in FIG. 2, except for stack order.

The support member 210 may be made of a thermally conductive material or a conductive material such as a metal or conductive ceramic. The support member 210 may be a single layer or include two or more layers.

That is, the support member 210 may be formed of a metal selected from Au, Ni, W, Mo, Cu, Al, Ta, Ag, Pt and Cr, or an alloy thereof and may be formed by laminating two or more different materials. In addition, the support member 210 may be implemented with a carrier wafer such as Si, Ge, GaAs, ZnO, SiC, SiGe, GaN or Ga2O3.

Such a support member 210 facilitates discharge of light emitted from the light-emitting device 200 and thereby improves thermal stability of the light-emitting device 200.

Meanwhile, the second electrode layer 215 may be formed on the support member 210 and the second electrode layer 215 may include at least one of an ohmic layer (not shown), a reflective layer (not shown) and a bonding layer (not shown). For example, the second electrode layer 215 may have a laminate structure of ohmic layer/reflective layer/bonding layer, ohmic layer/reflective layer, or reflective layer(including ohmic layer)/bonding layer, but the disclosure is not limited thereto. For example, the second electrode layer 215 may have a configuration in which a reflective layer and an ohmic layer are laminated in this order on an insulating layer.

The reflective layer (not shown) may be disposed between the ohmic layer (not shown) and the insulating layer (not shown) and may be formed of a highly reflective material, for example, Ag, Ni, Al, Rh, Pd, Ir, Ru, Mg, Zn, Pt, Au, or Hf or a combination thereof, or may be formed as a multilayer structure using this metal and a light-transmitting conductive material such as IZO, IZTO, IAZO, IGZO, IGTO, AZO, or ATO. In addition, the reflective layer (not shown) may have a laminate structure such as IZO/Ni, AZO/Ag, IZO/Ag/Ni or AZO/Ag/Ni. In addition, when the reflective layer (not shown) is formed of a material which ohmic-contacts the light emitting structure 270 (for example, the second semiconductor layer 250), the ohmic layer (not shown) may be not separately formed, but the disclosure is not limited thereto.

The ohmic layer (not shown) ohmic-contacts the lower surface of the light emitting structure and may be formed as a layer or in a plurality of patterns. The ohmic layer (not shown) may be selected from a light-transmitting electrode layer and a metal and may for example be implemented with a single layer or multiple layers using at least one of indium tin oxide (ITO), aluminum zinc oxide (AZO), indium zinc oxide (IZO), indium zinc tin oxide (IZTO), indium aluminum zinc oxide (IAZO), indium gallium zinc oxide (IGZO), indium gallium tin oxide (IGTO), antimony tin oxide (ATO), gallium zinc oxide (GZO), IrOx, RuOx, RuOx/ITO, Ni/IrOx/Au, and Ni/IrOx/Au/ITO. The ohmic layer (not shown) facilitates injection of carriers into the second semiconductor layer 250 and is not necessarily formed.

In addition, the second electrode layer 215 may include a bonding layer (not shown) and the bonding layer (not shown) may include a barrier or bonding metal and may for example include at least one of Ti, Au, Sn, Ni, Cr, Ga, In, Bi, Cu, Ag and Ta, but the disclosure is not limited thereto.

The light emitting structure includes at least the second semiconductor layer 250, the blocking layer 240, the intermediate layer 280, the active layer 230 and the first semiconductor layer 220, wherein the active layer 230 is interposed between the second semiconductor layer 250 and the first semiconductor layer 220.

The second semiconductor layer 250 may be formed on the second electrode layer 215. The second semiconductor layer 250 may be implemented with a p-type semiconductor layer doped with a p-type dopant. The p-type semiconductor layer may be selected from semiconductor materials having a formula of InxAlyGa1-x-yN (0≤x≤1, 0 ≤y≤1, 0≤x+y≤1), for example, selected from GaN, AlN, AlGaN, InGaN, InN, InAlGaN, AlInN and the like and may be doped with a p-type dopant such as Mg, Zn, Ca, Sr, or Ba.

The blocking layer 240 may be formed on the second semiconductor layer 250 and the intermediate layer 280 may be formed on the blocking layer 240. Composition, function, Al compositional ratio and bandgap relation of the blocking layer 240 and the intermediate layer 280 are the same as those of the embodiment shown in FIG. 2.

The active layer 230 may be formed with a single or multi-quantum well structure, a quantum wire structure, a quantum dot structure or the like using a compound semiconductor material of Group III-V elements.

In the case where the active layer 230 has a quantum well structure, for example, it may have a single- or multi-quantum well structure including a well layer having the formula of InxAlyGa1-x-yN (0≤x≤1, 0 ≤y≤1, 0≤x+y≤1) and a barrier layer having the formula of InaAlbGa1-a-bN (0≤a≤1, 0 ≤b≤1, 0≤a+b≤1). The well layer is formed of a material having a smaller band gap than that of the barrier layer.

A conductive clad layer (not shown) may be arranged on and/or under the active layer 230. The conductive clad layer (not shown) may be composed of an AlGaN-based semiconductor and may have a higher band gap than the active layer 230.

The first semiconductor layer 220 may be formed on the active layer 230. The first semiconductor layer 220 may be realized with an n-type semiconductor layer and the n-type semiconductor layer may be for example selected from semiconductor materials having the formula of InxAlyGa1-x-yN (0≤x≤1, 0 ≤y≤1, 0≤x+y≤1) such as GaN, AlN, AlGaN, InGaN, InN, InAlGaN and AlInN, and may be doped with an n-type dopant such as Si, Ge, Sn, Se or Te.

The first electrode layer 282 electrically connected to the first semiconductor layer 220 may be formed on the first semiconductor layer 220 and the first electrode layer 282 may include at least one pad and/or at least one electrode having a predetermined pattern. The first electrode layer 282 may be disposed in central, outside or edge portions of an upper surface of the first semiconductor layer 220, but the disclosure is not limited thereto. The first electrode layer 282 may be disposed in portions other than portions of the upper surface of the first semiconductor layer 220, but the disclosure is not limited thereto.

The first electrode layer 282 may be formed as a monolayer or multilayer structure using a conductive material, for example, a metal selected from In, Co, Si, Ge, Au, Pd, Pt, Ru, Re, Mg, Zn, Hf, Ta, Rh, Ir, W, Ti, Ag, Cr, Mo, Nb, Al, Ni, Cu and WTi, or an alloy thereof.

Meanwhile, the light emitting structure may include a third semiconductor layer (not shown) having a polarity opposite to that of the first semiconductor layer 220 on the first semiconductor layer 220. In addition, the second semiconductor layer 250 may be implemented with an n-type semiconductor layer and the first semiconductor layer 220 may be implemented with a p-type semiconductor layer. As a result, the light emitting structure may have at least one of np, pn, npn and pnp junction structures.

A light extraction structure 284 may be formed on the light emitting structure.

The light extraction structure 284 may be formed on the upper surface of the first semiconductor layer 220, or may be formed on the light-transmitting electrode layer (not shown) formed on the light emitting structure, but the disclosure is not limited thereto.

The light extraction structure 284 may be formed in a part or entirety of the upper surface of the light-transmitting electrode layer (not shown) or the first semiconductor layer 220. The light extraction structure 284 may be formed by etching at least one portion of the upper surface of the light-transmitting electrode layer (not shown), or the first semiconductor layer 220, but the disclosure is not limited thereto. The etching may include wet and/or dry etching. By the etching process, the upper surface of the light-transmitting electrode layer (not shown) or the upper surface of the first semiconductor layer 220 may include roughness forming the light extraction structure 284. The roughness having a random size may be irregularly formed, but the disclosure is not limited thereto. The roughness is a non-flat upper surface and includes at least one of a texture pattern, a roughness pattern and an uneven pattern.

A side cross-section of the roughness may have various shapes, such as cylindrical, polyprismatic, conical, polypyramidal, circular truncated conical and frusto pyramidal shapes and preferably include a conical or polypyramidal shape.

Meanwhile, the light extraction structure 284 may be formed by a method such as photoelectrochemical (PEC) etching, but the disclosure is not limited thereto. The light extraction structure 284 is formed on the upper surface of the light-transmitting electrode layer (not shown) or the first semiconductor layer 220, thereby preventing a phenomenon in which light emitted from the active layer 230 is total-reflected from the upper surface of the light-transmitting electrode layer (not shown) or the first semiconductor layer 220 and is then re-absorbed or scattered and contributing to improvement in light extraction efficiency of the light emitting device 200.

A passivation layer 290 may be formed on the side or upper surface of the light emitting structure and the passivation layer 290 may be made of an insulating material.

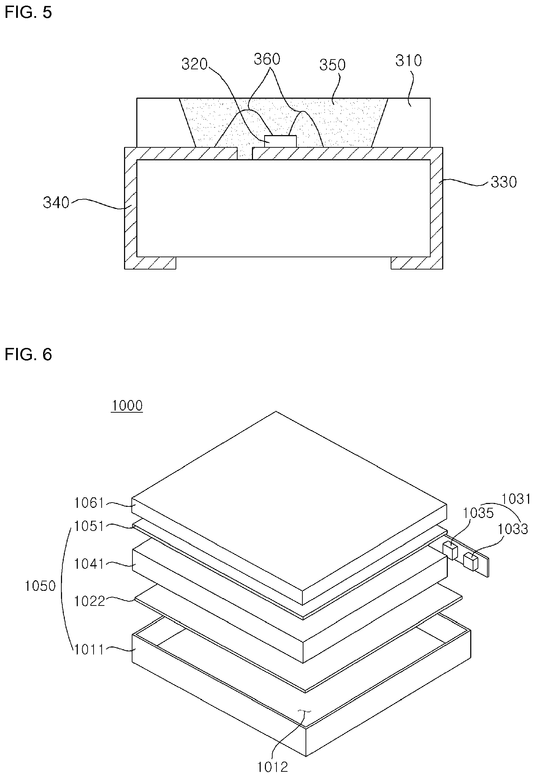

FIG. 5 is a sectional view illustrating a light emitting device package including the light emitting device according to the present embodiment.

Referring to FIG. 5, the light emitting device package 300 according to the present embodiment includes a body 310 provided with a cavity, a first electrode 330 and a second electrode 340 mounted on the body, a light source light 320 electrically connected to the first and second electrodes 330 and 340, and a sealing material 330 filling the cavity such that it covers the light source light 320.

The body 310 may be formed of at least one selected from resins such as polyphthalamide (PPA), silicon (Si), aluminum (Al), aluminum nitride (AlN), liquid crystal polymer (photosensitive glass (PSG)), polyamide 9T (PA9T), syndiotactic polystyrene (SPS), a metal, sapphire (Al2O3), beryllium oxide (BeO), a printed circuit board (PCB) and a ceramic. In addition, the body 310 may be formed by injection molding, etching or the like, but the formation method is not limited thereto.

The inner surface of the body 310 may be provided with an inclined plane and, in particular, a reflection angle of light emitted from the light emitting device 320 may vary depending on the angle of the inclined plane and as a result, an orientation angle of light emitted to the outside may be controlled.

As orientation angle of light decreases, concentration of light emitted from the light source unit 320 to the outside increases, and as orientation angle of light increases, concentration of light emitted from the light source unit 320 to the outside decreases.

Meanwhile, as seen from the top, the cavity provided in the body 310 may have various shapes such as a circular shape, a rectangular shape, a polygonal shape, an oval shape and a shape with curved corners, but the disclosure is not limited thereto.

The light source unit 320 is disposed in the cavity of the body 310 and the light source unit 320 may be for example any one of the light emitting devices shown in FIGS. 1 to 4. The light emitting device may be an ultraviolet (UV) device, but the disclosure is not limited thereto. In addition, one or more light emitting devices may be mounted.

The body 310 may include the first electrode 330 and the second electrode 340. The first electrode 330 and the second electrode 340 are electrically connected to the light source unit 320 and supply power to the light source unit 320.

In addition, the first electrode 330 and the second electrode 340 are electrically separated from each other and reflect light generated by the light source unit 320 to improve luminous efficacy and discharge heat generated by the light source unit 320 to the outside.

As shown in FIG. 5, both the first electrode 330 and the second electrode 340 are bonded to the light source unit 320 via a wire 360, but the disclosure is not limited thereto. In particular, in a vertical light emitting device, any one of the first electrode 330 and the second electrode 340 may be bonded to the light source unit 320 via the wire 360 and it may be electrically connected thereto without the wire 360. Accordingly, when power is supplied to the first and second electrodes 330 and 340, the power may be applied to the light emitting device 530. Meanwhile, a plurality of lead frames (not shown) are mounted in the body 310 and each lead frame (not shown) may be electrically connected to the light emitting device, but the disclosure is not limited thereto.

The first electrode 330 and the second electrode 340 may contain a metal such as titanium (Ti), copper (Cu), nickel (Ni), gold (Au), chromium (Cr), tantalum (Ta), platinum (Pt), tin (Sn), silver (Ag), phosphorus (P), aluminum (Al), indium (In), palladium (Pd), cobalt (Co), silicon (Si), germanium (Ge), hafnium (Hf), ruthenium (Ru), iron (Fe), and alloys thereof. In addition, the first and second electrodes 340 and 340 may have a monolayer or multilayer structure, but the disclosure is not limited thereto.

The sealing material (not shown) may be filled in the cavity so as to cover the light source unit 320.

The sealing material 330 may contain a silicone, epoxy or other resin and may be formed by filling the cavity with a resin, followed by UV or heat curing.

In addition, the sealing material (not shown) may include a phosphor, and the phosphor is selected depending on the wavelength of light emitted from the light source unit 320 to allow the light emitting device package 300 to render white light.

Depending on the wavelength of light emitted from the light source unit 320, the phosphor may be at least one of blue light emitting phosphors, blue-green light emitting phosphors, green light emitting phosphors, yellow-green light emitting phosphors, yellow light emitting phosphors, yellow-red light emitting phosphors, orange light emitting phosphors, and red light emitting phosphors.

That is, the phosphor (now shown) is excited by first light emitted from the light source unit 320 to produce second light. For example, in a case where the light source unit 320 is a UV light emitting diode and the phosphor includes a combination of red, green and blue phosphors, UV light generated by the UV light emitting diode passes through the red, green and blue phosphors and is then excited, providing white light.

Such a phosphor may be a known phosphor such as YAG, TAG, sulfides, silicates, aluminates, nitrides, carbides, nitridosililcates, borates, fluorides and phosphates.

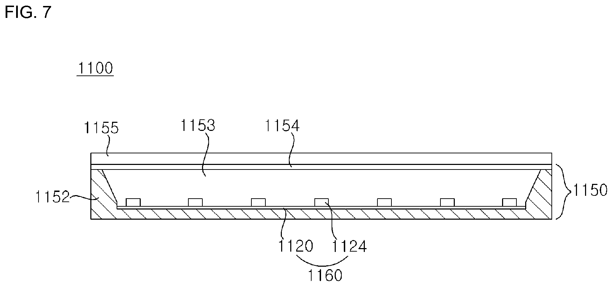

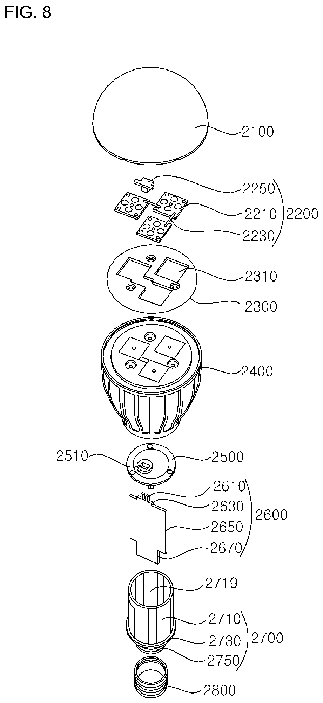

The light emitting device according to the present embodiment may be applied to a lighting system. The lighting system includes an array of a plurality of light emitting devices, may include a display device as shown in FIGS. 6 and 7, a lighting device as shown in FIG. 8, or a light, traffic light, vehicle headlight, electronic board or the like.

FIG. 6 is an exploded perspective view illustrating a display device including a light emitting device according to an embodiment.

Referring to FIG. 6, the display device 1000 according to the present embodiment includes a light-guide plate 1041, a light source module 1031 for supplying light to the light-guide plate 1041, a reflective member 1022 disposed under the light-guide plate 1041, an optical sheet 1051 disposed on the light-guide plate 1041, a display panel 1061 disposed on the optical sheet 1051, and a bottom cover 1011 accommodating the light-guide plate 1041, the light source module 1031 and the reflective member 1022, but the disclosure is not limited thereto.

The bottom cover 1011, the reflective sheet 1022, the light-guide plate 1041 and the optical sheet 1051 may be defined as a light unit 1050.

The light-guide plate 1041 functions to diffuse light, thereby providing a surface light source. The light-guide plate 1041 is formed of a transparent material, for example, an acrylic resin such as polymethylmethacrylate (PMMA), polyethylene terephthalate (PET), polycarbonate (PC), a cycloolefin copolymer (COC) or a polyethylene naphthalate (PEN) resin.

The light source module 1031 supplies light to at least one side of the light guide plate 1041 and ultimately functions as a light source of the display device.

The number of the light source module 1031 may be one or more and the light source module 1031 directly or indirectly supplies light from a side surface of the light-guide plate 1041. The light source module 1031 includes a substrate 1033 and a plurality of light emitting devices 1035 according to the present embodiment and the light emitting devices 1035 may be arrayed by a predetermined distance on the substrate 1033.

The substrate 1033 may be a printed circuit board (PCB) including a circuit pattern (not shown). The substrate 1033 may include not only a general PCB but also a metal core PCB (MCPCB), a flexible PCB or the like, but the disclosure is not limited thereto. When the light emitting devices 1035 are mounted on a side surface of the bottom cover 1011 or an upper surface of the heat radiation plate, the substrate 1033 may be removed. A portion of the heat radiation plate may contact an upper surface of the bottom cover 1011.

In addition, the light emitting devices 1035 may be mounted on the substrate 1033 such that a light-emission surface is spaced from the light-guide plate 1041 by a predetermined distance, but the disclosure is not limited thereto. The light emitting device 1035 may directly or indirectly supply light to a light-receiving region which is a side surface of the light-guide plate 1041, but the disclosure is not limited thereto.

The reflective member 1022 may be disposed under the light-guide plate 1041. The reflective member 1022 reflects light incident upon a lower surface of the light-guide plate 1041 such that the light travels upward, thereby improving brightness of the light unit 1050. The reflective member 1022 may be formed of a material, for example, a PET, PC or PVC resin, or the like, but the disclosure is not limited thereto. The reflective member 1022 may correspond to the upper surface of the bottom cover 1011, but the disclosure is not limited thereto.

The bottom cover 1011 may accommodate the light-guide plate 1041, the light source module 1031, the reflective member 1022 and the like. For this purpose, the bottom cover 1011 may include an accommodation portion 1012 having a box shape having an open upper surface, but the disclosure is not limited thereto. The bottom cover 1011 may be bonded to a top cover, but the disclosure is not limited thereto.

The bottom cover 1011 may be formed of a metal or resin material and may be formed by a molding process such as press molding or extrusion molding. In addition, the bottom cover 1011 may include a highly thermally conductive metal or a non-metal material, but the disclosure is not limited thereto.

The display panel 1061 is for example an LCD panel, which includes first and second substrates that face each other and are formed of a transparent material, and a liquid crystal layer disposed between the first and second substrates. A polarization plate may be bonded to at least one surface of the display panel 1061 and the bonding structure of the polarization plate is not limited thereto. The display panel 1061 displays information by light passing through the optical sheet 1051. The display device 1000 may be applied to a variety of cellular terminals, monitors for notebook computers, monitors for laptop computers, televisions and the like.

The optical sheet 1051 is disposed between the display panel 1061 and the light-guide plate 1041 and includes at least one light-transmitting sheet. The optical sheet 1051 may for example include at least one of diffusion sheets, horizontal and vertical prism sheets, and brightness-reinforcing sheets. The diffusion sheet diffuses incident light, the horizontal and/or vertical prism sheet focuses incident light upon a display area and the brightness-reinforcing sheet reuses lost light and thereby improves brightness. In addition, a protective sheet may be disposed on the display panel 1061, but the disclosure is not limited thereto.

Here, the light-guide plate 1041 or the optical sheet 1051 as optical members may be disposed in a light passage of the light source module 1031, but the disclosure is not limited thereto.

FIG. 7 is a sectional view illustrating a display device including a light emitting device according to an embodiment.

Referring to FIG. 7, the display device 1100 includes a bottom cover 1152, a substrate 1120 on which light emitting devices 1124 are arrayed, an optical member 1154, and a display panel 1155.

The substrate 1120 and the light emitting devices 1124 may be defined as a light source module 1160. The bottom cover 1152, at least one light source module 1160 and the optical member 1154 may be defined as a light unit 1150. The bottom cover 1152 may include an accommodation portion 1153, but the disclosure is not limited thereto. The light source module 1160 includes a substrate 1120 and a plurality of light emitting devices 1124 disposed on the substrate 1120.

Here, the optical member 1154 may include at least one of a lens, a light-guide plate, a diffusion sheet, horizontal and vertical prism sheets, a brightness-reinforcing sheet and the like. The light-guide plate may be formed of a PC or polymethyl methacrylate (PMMA) material and the light-guide plate may be removed. The diffusion sheet diffuses incident light, the horizontal and vertical prism sheets focus incident light upon a display area and the brightness-reinforcing sheet reuses lost light and thereby improves brightness.

The optical member 1154 is disposed on the light source module 1160 and converts light emitted from the light source module 1160 into surface light, or diffuses or focuses the light.

FIG. 8 is an exploded perspective view illustrating a lighting device including a light emitting device according an embodiment.

Referring to FIG. 8, the lighting device according to the present invention includes a cover 2100, a light source module 2200, a heat radiator 2400, a power supply 2600, an inner case 2700 and a socket 2800. In addition, the lighting device according to the present invention may further include at least one of a member 2300 and a holder 2500. The light source module 2200 may include the light emitting device according to the embodiment.

For example, the cover 2100 may have a bulb or hemispherical hollow shape having an open portion. The cover 2100 may be optically bonded to the light source module 2200. For example, the cover 2100 diffuses, scatters or excites light emitted from the light source module 2200. The cover 2100 may be a type of optical member. The cover 2100 may be bonded to the heat radiator 2400. The cover 2100 may have a bonding portion bonded to the heat radiator 2400.

An inner surface of the cover 2100 may be coated with an ivory-white coating material. The ivory-white coating material may include a diffusion material for diffusing light. A surface roughness of the inner surface of the cover 2100 may be greater than that of an outer surface thereof. The reason for this is that light is sufficiently scattered and diffused from the light source module 2200 and is then discharged to the outside.

The cover 2100 may be formed of a material such as glass, plastic, polypropylene (PP), polyethylene (PE) or polycarbonate (PC). Of these, polycarbonate has high light resistance, heat resistance and strength. The cover 2100 may be transparent so that the light source module 2200 is visible from outside, or be non-transparent. The cover 2100 may be formed by blow molding.

The light source module 2200 may be disposed on a surface of the heat radiator 2400. Accordingly, heat is conducted from the light source module 2200 to the heat radiator 2400. The light source module 2200 may include a plurality of light emitting devices 2210, at least one connection plate 2230 and a connector 2250.

The member 2300 is disposed on an upper surface of the heat radiator 2400 and a plurality of guide grooves 2310 into which the light emitting devices 2210 and the connector 2250 are inserted. The guide grooves 2310 correspond to a substrate of the light emitting device 2210 and the connector 2250.

A light-reflecting material is applied or coated onto a surface of the member 2300. For example, a white coating material may be coated or applied onto the surface of the member 2300. The member 2300 reflects light, which is reflected to an inner surface of the cover 2100 and returns back to the light source module 2200, toward the cover 2100. Accordingly, luminous efficacy of the lighting device according to the present invention is improved.

The member 2300 is for example formed of an insulating material. The connection plate 2230 of the light source module 2200 may include an electrically conductive material. Accordingly, the heat radiator 2400 may electrically contact the connection plate 2230. The member 2300 is formed of an insulating material and thereby prevents short circuit between the connection plate 2230 and the heat radiator 2400. The heat radiator 2400 receives heat from the light source module 2200 and the power supply 2600 and then radiates the same.

The holder 2500 clogs an accommodation groove 2719 of an insulation portion 2710 of the inner case 2700. Accordingly, the power supply 2600 accommodated in the insulation portion 2710 of the inner case 2700 is sealed. The holder 2500 has a guide protrusion 2510. The guide protrusion 2510 may include a hole through which the protrusion 2610 of the power supply 2600 passes.

The power supply 2600 processes or converts an electrical signal supplied from the outside and then supplies the same to the light source module 2200. The power supply 2600 is accommodated in the accommodation groove 2719 of the inner case 2700 and is sealed in the inner case 2700 through the holder 2500.

The power supply 2600 may include a protrusion 2610, a guide portion 2630, a base 2650 and a protrusion 2670.

The guide portion 2630 protrudes to the outside from a side of the base 2650. The guide portion 2630 may be inserted into the holder 2500. A plurality of elements may be disposed on a surface of the base 2650. The elements for example include DC power conversion systems converting alternating current supplied from an exterior power source into direct current, driving chips for controlling operation of the light source module 2200, and electrostatic discharge (ESD) protection devices for protecting the light source module 2200, but the disclosure is not limited thereto.

The protrusion 2670 protrudes to the outside from another side of the base 2650. The protrusion 2670 is inserted into the connection portion 2750 of the inner case 2700 and receives an electrical signal from the outside. For example, a size of the protrusion 2670 may be smaller than or equal to that of the connection portion 2750 of the inner case 2700. One terminal of a positive (+) wire and a negative (-) wire is electrically connected to the protrusion 2670 and the other terminal is electrically connected to the socket 2800.

The inner case 2700 may include a molding portion in addition to the power supply 2600. The molding portion is an area formed by hardening a molding liquid and fixes the power supply 2600 to an inner area of the inner case 2700.

The light emitting device according to the embodiments has a configuration in which the intermediate layer and the blocking layer are interposed between the second semiconductor layer and the active layer, thus reducing piezoelectric polarization and improving probability of recombination between electrons and holes in the active layer.

In addition, advantageously, deterioration in brightness of light emitting devices can be prevented by reducing an amount of p-type dopant diffused into the active layer.

In addition, according to embodiments, luminous efficacy is improved and operation voltage of the light emitting device is thus decreased.

Although embodiments have been described with reference to a number of illustrative embodiments thereof, it should be understood that numerous other modifications and applications may be devised by those skilled in the art that will fall within the intrinsic aspects of the embodiments. More particularly, various variations and modifications are possible in concrete constituent elements of the embodiments. In addition, it is to be understood that differences relevant to the variations and modifications fall within the scope of the present disclosure defined in the appended claims.

## Claims

1. A light emitting diode comprising:
a first semiconductor layer (120) doped with an n-type dopant;
a second semiconductor layer (150) doped with a p-type dopant;
an active layer (130) disposed between the first semiconductor layer (120) and the second semiconductor layer (150), the active layer (130) being formed of InₓAl_{y}Ga_{1-x-y}N (0≤x≤1, 0≤y≤1, 0≤x+y≤1) and including a plurality of barrier layers (B1, B2, B3) and a plurality of well layers (Q1, Q2, Q3), the well layers (Q1, Q2, Q3) being interposed between the barrier layers (B1, B2, B3) and having a smaller bandgap energy than that of the barrier layers (B1, B2, B3);
an intermediate layer (180) interposed between the active layer (130) and the second semiconductor layer (150), the intermediate layer (180) being formed of InₐAl_{b}Ga_{1-a-b}N (0≤a≤1, 0≤b≤1, 0≤a+b≤1) and having a smaller bandgap energy than that of the barrier layers (B1, B2, B3), the intermediate layer (180) doped with a p-type dopant; and
a blocking layer (140) disposed between the intermediate layer (180) and the second semiconductor layer (150), the blocking layer (140) being formed of In_{z}Al_{w}Ga_{1-z-w}N (0≤z≤1, 0≤w≤1, 0≤z+w≤1) and having a greater bandgap energy than that of each of the barrier layers (B1, B2, B3) and the intermediate layer (180),
wherein an Al content of the intermediate layer (180) is lower than that of the barrier layers (B1, B2, B3) and the blocking layer (140) and is higher than that of the well layers (Q1, Q2, Q3), and
wherein the blocking layer (140) is doped with a p-type dopant,
**characterized in that** the intermediate layer (180) has an A1 composition ratio of 0.02 to 0.13, and
wherein an A1 content of the barrier layers (B1, B2, B3) is higher than that of the well layers (Q1, Q2, Q3) and is lower than that of the blocking layer (140), and
wherein the active layer (130) produces UV light having a wavelength of 325 nm to 385 nm, and
wherein the blocking layer (140) has a constant bandgap energy therein, and contacts directly with the intermediate layer (180) and the second semiconductor layer (150).

2. The light emitting diode according to claim 1, wherein each of the well layers (Q1, Q2, Q3) and the barrier layers (B1, B2, B3) has a thickness of 4 to 20 nm.

3. The light emitting diode according to any one of claims 1 to 2, wherein the p-type dopant of the intermediate layer (180) includes at least one of Mg, Zn, Ca, Sr and Ba.

4. The light emitting diode according to any one of claims 1 to 3, wherein the intermediate layer (180) has a doping concentration of 1E¹⁸ to 1E²⁰ cm⁻³.

5. The light emitting diode according to any one of claims 1 to 2, wherein the intermediate layer (180) has a thickness of 2 nm to 30 nm.

6. The light emitting diode according to any one of claims 1 to 2, wherein the well layers (Q1, Q2, Q3) and the barrier layers (B1, B2, B3) are alternately disposed and the number of the well layers (Q1, Q2, Q3) is 3 to 5.

7. The light emitting diode according to any one of claims 1 to 2, further comprising:
a first electrode (172) electrically connected to the first semiconductor layer (120); and
a second electrode (174) electrically connected to the second semiconductor layer (150).

8. The light emitting diode according to any one of claims 1 to 2, further comprising a light-transmitting electrode layer (170) disposed on the second semiconductor layer (150).

9. The light emitting diode according to any one of claims 1 to 2, further comprising a substrate (110) disposed under the first semiconductor layer (120).

10. The light emitting diode according to claim 9, wherein the substrate (110) includes a plurality of irregularities on a upper surface thereof to improve light extraction efficiency.

## Patentansprüche

1. Leuchtdiode umfassend:
eine erste Halbleiterschicht (120), die mit einem n-Typ-Dotiermittel dotiert ist;
eine zweite Halbleiterschicht (150), die mit einem p-Typ-Dotiermittel dotiert ist;
eine aktive Schicht (130), die zwischen der ersten Halbleiterschicht (120) und der zweiten Halbleiterschicht (150) angeordnet ist, wobei die aktive Schicht (130) aus lnₓAl_{y}Ga_{1-x-y}N (0≤x≤1, 0≤y≤1, 0≤x+y≤1) gebildet ist und eine Vielzahl von Barrierenschichten (B1, B2, B3) und eine Vielzahl von Wellschichten (Q1, Q2, Q3) umfasst, wobei die Wellschichten (Q1, Q2, Q3) zwischen den Barrierenschichten (B1, B2, B3) positioniert sind und eine kleinere Bandgapenergie als jene der Barrierenschichten (B1, B2, B3) aufweisen;
eine Zwischenschicht (180), die zwischen der aktiven Schicht (130) und der zweiten Halbleiterschicht (150) positioniert ist, wobei die Zwischenschicht (180) aus InₐAl_{b}Ga_{1-a-b}N (0≤a≤1, 0≤b≤1, 0≤a+b≤1) gebildet ist und eine kleinere Bandgapenergie als jene der Barrierenschichten (B1, B2, B3) aufweist, wobei die Zwischenschicht (180) mit einem p-Typ-Dotiermittel dotiert ist; und
eine Blockierschicht (140), die zwischen der Zwischenschicht (180) und der zweiten Halbleiterschicht (150) positioniert ist, wobei die Blockierschicht (140) aus In_{z}Al_{w}Ga_{1-z-w}N (0≤z≤1, 0≤w≤1, 0≤z+w≤1) gebildet ist und eine größere Bandgapenergie als jene von jeder der Barrierenschichten (B1, B2, B3) und der Zwischenschicht (180) aufweist,
wobei ein Al-Gehalt der Zwischenschicht (180) niedriger als jener der Barrierenschichten (B1, B2, B3) und der Blockierschicht (140) ist und höher als jener der Wellschichten (Q1, Q2, Q3) ist, und
wobei die Blockierschicht (140) mit einem p-Typ-Dotiermittel dotiert ist,
**dadurch gekennzeichnet, dass** die Zwischenschicht (180) ein Al-Zusammensetzungsverhältnis von 0,02 bis 0,13 aufweist, und
wobei ein Al-Gehalt der Barrierenschichten (B1, B2, B3) höher als jener der Wellschichten (Q1, Q2, Q3) ist und niedriger als jener der Blockierschicht (140) ist, und
wobei die aktive Schicht (130) UV-Licht erzeugt, das eine Wellenlänge von 325 nm bis 385 nm aufweist, und
wobei die Blockierschicht (140) eine konstante Bandgapenergie darin aufweist, und direkt mit der Zwischenschicht (180) und der zweiten Halbleiterschicht (150) in Kontakt ist.

2. Leuchtdiode nach Anspruch 1, wobei jede der Wellschichten (Q1, Q2, Q3) und der Barrierenschichten (B1, B2, B3) eine Dicke von 4 bis 20 nm aufweist.

3. Leuchtdiode nach einem der Ansprüche 1 bis 2, wobei das p-Typ-Dotiermittel der Zwischenschicht (180) Mg, Zn, Ca, Sr und/oder Ba umfasst.

4. Leuchtdiode nach einem der Ansprüche 1 bis 3, wobei die Zwischenschicht (180) eine Dotierkonzentration von 1E¹⁸ bis 1E²⁰ cm⁻³ aufweist.

5. Leuchtdiode nach einem der Ansprüche 1 bis 2, wobei die Zwischenschicht (180) eine Dicke von 2 nm bis 30 nm aufweist.

6. Leuchtdiode nach einem der Ansprüche 1 bis 2, wobei die Wellschichten (Q1, Q2, Q3) und die Barrierenschichten (B1, B2, B3) abwechselnd angeordnet sind und die Anzahl der Wellschichten (Q1, Q2, Q3) 3 bis 5 ist.

7. Leuchtdiode nach einem der Ansprüche 1 bis 2, ferner umfassend:
eine erste Elektrode (172), die mit der ersten Halbleiterschicht (120) elektrisch verbunden ist; und
eine zweite Elektrode (174), die mit der zweiten Halbleiterschicht (150) elektrisch verbunden ist.

8. Leuchtdiode nach einem der Ansprüche 1 bis 2, ferner umfassend eine Lichtübertragungselektrodenschicht (170), die an der zweiten Halbleiterschicht (150) angeordnet ist.

9. Leuchtdiode nach einem der Ansprüche 1 bis 2, ferner umfassend ein Substrat (110), das unter der ersten Halbleiterschicht (120) angeordnet ist.

10. Leuchtdiode nach Anspruch 9, wobei das Substrat (110) eine Vielzahl von Unregelmäßigkeiten an einer oberen Oberfläche davon aufweist, um eine Lichtextraktionseffizienz zu verbessern.

## Revendications

1. Une diode électroluminescente comprenant :
une première couche semi-conductrice (120) dopée avec un dopant de type n ;
une deuxième couche semi-conductrice (150) dopée avec un dopant de type p ;
une couche active (130) disposée entre la première couche semi-conductrice (120) et la deuxième couche semi-conductrice (150), la couche active (130) étant formée de InₓAl_{y}Ga_{1-x-y}N (0≤x≤1, 0≤y≤1, 0≤x+y≤1) et comprenant une pluralité de couches barrières (B1, B2, B3) et une pluralité de couches de puits (Q1, Q2, Q3), les couches de puits (Q1, Q2, Q3) étant interposées entre les couches barrières (B1, B2, B3) et ayant une énergie de bande interdite plus faible que celle des couches barrières (B1, B2, B3) ;
une couche intermédiaire (180) interposée entre la couche active (130) et la deuxième couche semi-conductrice (150), la couche intermédiaire (180) étant formée de InₐAl_{b}Ga_{1-a-b}N (0≤a≤1, 0≤b≤1, 0≤a+b≤1) et ayant une énergie de bande interdite plus faible que celle des couches barrières (B1, B2, B3), la couche intermédiaire (180) étant dopée avec un dopant de type p ; et
une couche de blocage (140) disposée entre la couche intermédiaire (180) et la deuxième couche semi-conductrice (150), la couche de blocage (140) étant formée de : In_{z}Al_{w}Ga_{1-z-w}N (0≤z≤1, 0≤w≤1, 0≤z+w≤1) et ayant une énergie de bande interdite supérieure à celle de chacune des couches barrières (B1, B2, B3) et de la couche intermédiaire (180),
une teneur en Al de la couche intermédiaire (180) est inférieure à celle des couches barrière (B1, B2, B3) et de la couche de blocage (140), et est supérieure à celle des couches de puits (Q1, Q2, Q3), et
la couche de blocage (140) étant dopée avec un dopant de type p,
**caractérisé en ce que** la couche intermédiaire (180) a un rapport de composition d'Al compris entre 0,02 et 0,13, et
une teneur en Al des couches barrière (B1, B2, B3) étant plus élevée que celle des couches de puits (Q1, Q2, Q3) et est inférieure à celle de la couche de blocage (140), et
la couche active (130) produisant une lumière UV ayant une longueur d'onde de 325 nm à 385 nm, et
la couche de blocage (140) a en elle une énergie de bande interdite constante, et est directement en contact avec la couche intermédiaire (180) et la deuxième couche semi-conductrice (150).

2. La diode électroluminescente selon la revendication 1, dans laquelle chacune des couches de puits (Q1, Q2, Q3) et les couches barrière (B1, B2, B3) ont une épaisseur de 4 à 20 nm.

3. La diode électroluminescente selon l'une quelconque des revendications 1 à 2, dans laquelle le dopant de type p de la couche intermédiaire (180) comprend au moins un parmi : Mg, Zn, Ca, Sr et Ba.

4. La diode électroluminescente selon l'une quelconque des revendications 1 à 3, dans laquelle la couche intermédiaire (180) a une concentration de dopage de 1E¹⁸ à 1E²⁰ cm⁻³.

5. La diode électroluminescente selon l'une quelconque des revendications 1 à 2, dans laquelle la couche intermédiaire (180) a une épaisseur de 2 nm à 30 nm.

6. La diode électroluminescente selon l'une quelconque des revendications 1 à 2, dans laquelle les couches de puits (Q1, Q2, Q3) et les couches barrière (B1, B2, B3) sont disposées alternativement et le nombre de couches de puits (Q1, Q2, Q3) est de 3 à 5.

7. La diode électroluminescente selon l'une quelconque des revendications 1 à 2, comprenant en outre :
une première électrode (172) connectée électriquement à la première couche semi-conductrice (120) ; et
une deuxième électrode (174) connectée électriquement à la deuxième couche semi-conductrice (150).

8. La diode électroluminescente selon l'une quelconque des revendications 1 à 2, comprenant en outre une couche formant électrode de transmission de lumière (170) disposée sur la deuxième couche semi-conductrice (150).

9. La diode électroluminescente selon l'une quelconque des revendications 1 à 2, comprenant en outre un substrat (110) disposé sous la première couche semi-conductrice (120).

10. La diode électroluminescente selon la revendication 9, dans laquelle le substrat (110) comprend une pluralité d'irrégularités sur sa surface supérieure pour améliorer l'efficacité d'extraction de la lumière.
